Europäisches Patentamt

European Patent Office

Office européen des brevets

(11) Publication number: **0 268 430**
**A2**

# EUROPEAN PATENT APPLICATION

(21) Application number: 87310013.5

(22) Date of filing: 12.11.87

(51) Int. Cl.⁴: **H 03 K 17/73**
H 03 K 17/78, H 01 L 29/74,
H 01 L 31/10

(30) Priority: 14.11.86 JP 269741/86
31.07.87 JP 190187/87

(43) Date of publication of application:
25.05.88 Bulletin 88/21

(84) Designated Contracting States: **DE FR NL**

(71) Applicant: **Oki Electric Industry Company, Limited**
**7-12, Toranomon 1-chome Minato-ku**
**Tokyo 105 (JP)**

(72) Inventor: **Mizuuchi, Kenji§Oki Electric Industry Co., Ltd.**
**7-12 Toranomon 1-chome**
**Minato-ku Tokyo (JP)**

**Otani, Haruo§Oki Electric Industry Co., Ltd.**
**7-12 Toranomon 1-chome**
**Minato-ku Tokyo (JP)**

**Hagimura, Kazuo§Oki Electric Industry Co., Ltd.**
**7-12 Toranomon 1-chome**
**Minato-ku Tokyo (JP)**

(74) Representative: **Read, Matthew Charles et al**
**Venner Shipley & Co. 368 City Road**
**London EC1V 2QA (GB)**

(54) **An optically coupled semiconductor switch and driving method adapted thereto.**

㉗ A PNPN semiconductor switch can be optically turned-off to electrically isolate a circuit system from a control system. An optically coupled semiconductor switch driven by a first LED comprises a second LED and a switching circuit driven by the second LED connected in parallel to a resistor connected between a P gate and a cathode of the switch.

EP 0 268 430 A2

## Description

# AN OPTICALLY COUPLED SEMICONDUCTOR SWITCH AND DRIVING METHOD ADAPTED THERETO

### BACKGROUND OF THE INVENTION

This invention relates to an optically coupled semiconductor switch and more particularly relates to an optically coupled PNPN switch with a turn-off mechanism and a driving method adapted thereto.

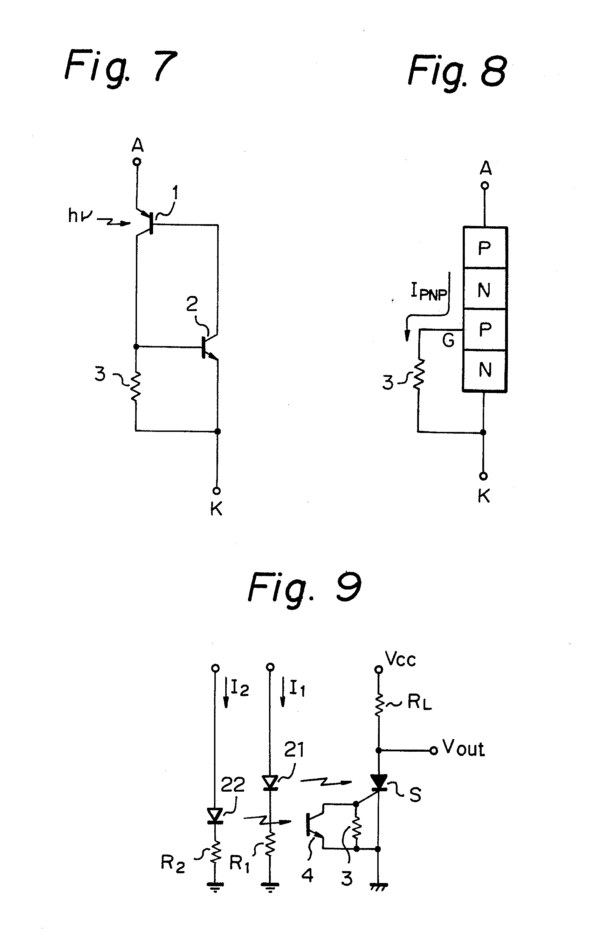

Fig. 7 shows an equivalent circuit diagram of a prior art optical PNPN switch constituted of a PNP transistor 1 and an NPN transistor 2. The PNPN switch will turn on under the condition of the following formula:

$$\alpha \, PNP + \alpha \, NPN \geqq 1 \quad ..... \ (1)$$

where $_{PNP}$ is a d.c. current multiplication ratio of the PNP transistor 1 and $\alpha \, _{NPN}$ is that of the NPN transistor 2.

In an usual PNPN device, a small leakage current may cause the device turns into a conductive state because both the multification ratios $\alpha \, _{PNP}$ and $\alpha \, _{NPN}$ are so designed so as to comply with the equation (1).

A shunt resistor 3 between the emitter and the base of the NPN transistor 2 can block the current because the multification ratio $\alpha \, _{NPN}$ reduces to a low level effectively and extremely.

Next, the optical turn-on mechanism mentioned above will be described with reference to Fig. 8.

In Fig. 8, when the PNPN device is exposed to light, a PNP transistor 1 is activated and an optical current $I_{PNP}$ through the resistor $R_{GK}3$ developes a voltage $V_{GK}(= I_{PNP}R_{GK})$ across the resistor $R_{GK}$.

When the voltage $V_{GK}$ reaches an approximately enough level, for example 0.6 volts, to activate the NPN transistor 2, the multiplication ratio $\alpha \, _{NPN}$ increases to satisfy the equation (1) and the turn-on operation occurrs.

Once the turn-on operation makes the device conductive, as the voltage $V_{GK}$ is kept approximately more than 0.6 volts, the device will keep its turned-off condition even though the light is eliminated.

This function is well recognized as a self maintenance function.

In other words, the turn-off condition cannot be achieved without removing of an anode current which makes the voltage $V_{GK}$less than 0.6 volts. Accordingly, an optically controlled turn-off cannot be achieved in the prior art PNPN switch.

### SUMMARY OF THE INVENTION

It is an object of this invention to provide an improved PNPN semiconductor switch capable of optically controling its turn-on and turn-off functions.

Another object of this invention is to provide a novel driving method adapted to the above improved PNPN semiconductor switch.

According to this invention, there is provided a PNPN semiconductor switch comprising (a) a resistor connected between the P gate and the cathode of the PNPN semiconductor switch, (b) a first LED (Light Emitting Diode) for driving the switch, (c) a second LED and (d) a switching circuit for shunting a voltage between the P gate and the cathode whereby the PNPN switch can be turned-off when the PNPN switch is exposed to light radiation from the second LED.

And, there is also provided a method for driving a PNPN semiconductor switch comprising steps of (a) driving the PNPN switch by a first LED, the P gate and the cathode of the PNPN switch being connected through a resistor; (b) turning off the PNPN switch by closing the P gate and the cathode driven by a second LED; (c) preserving the closing condition between the P gate and the cathode by providing the second LED with a small current when the PNPN switch remains off-state.

### BRIEF DESCRIPTION OF THE DRAWINGS

In the accompanying drawings:

Fig. 1 is a principle circuit diagram of the optically coupled PNPN switch according to the present invention;

Fig. 2 is a circuit diagram showing the first embodiment of this invention;

Fig. 3 is an equivalent circuit diagram of the PNPN switch shown in Fig. 2;

Fig. 4 is a cross-sectional view of the optically coupled PNPN switch device shown in Fig. 3;

Fig. 5 is a circuit diagram showing the second embodiment of this invention;

Fig. 6 is a circuit diagram showing a third embodiment of this invention;

Fig. 7 is an equivalent circuit diagram showing a prior art PNPN switch;

Fig. 8 is a constructional view showing a prior art PNPN switch;

Fig. 9 is a driving circuit diagram adapted to the present invention;

Fig. 10 is a wave form chart illustrating an operation of the optically coupled semiconductor switch shown in Fig. 9;

Fig. 11 is a driving circuit diagram adapted to the second embodiment of this invention; and

Fig. 12 is a wave form chart illustrating an operation of the optically coupled semiconductor switch shown in Fig. 11.

### DESCRIPTION OF THE PREFERRED EMBODIMENT

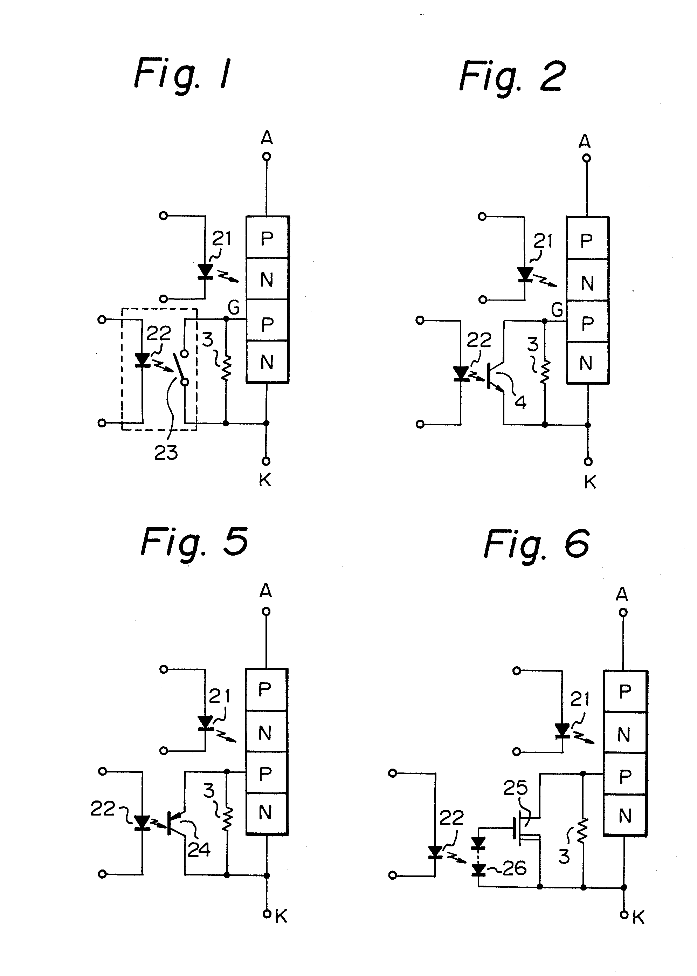

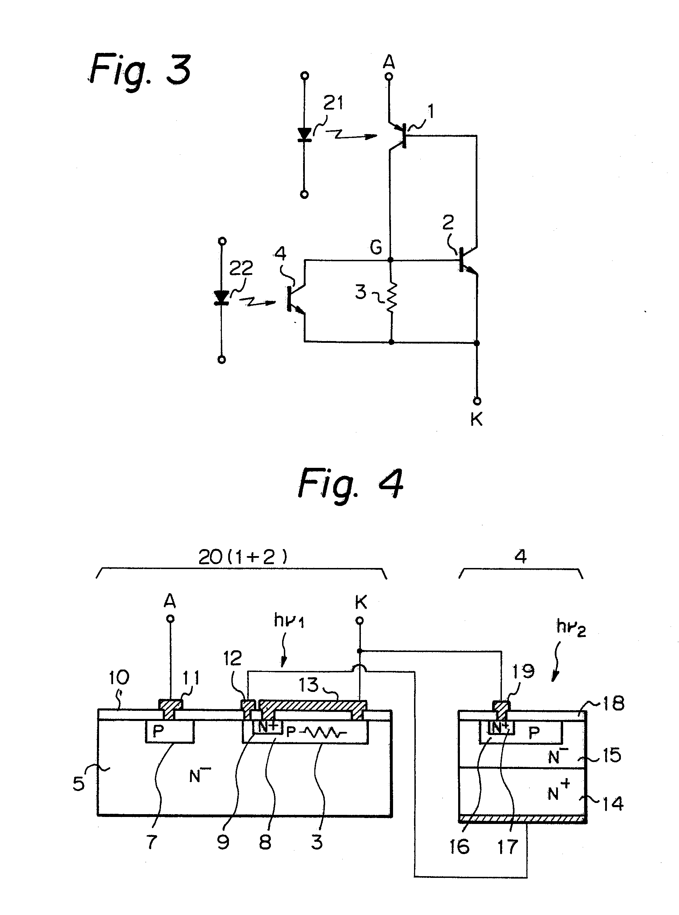

A preferred embodiment of this invention will now be described with reference to Figs. 1, 2, 3 and 4 which relate to an optically coupled semiconductor switch.

Identical elements in Figs. 1, 2, 3 and 4 corresponding to those in Figs. 7 and 8 are shown bearing the same numbers or marks.

In an optically coupled semiconductor switch according to this invention, there are provided, as shown in Fig. 1, a resistor $R_{GK}3$ connected between the P-gate and the cathode of a photo PNPN switch, an LED 21 for driving the optically coupled semiconductor switch, an LED 22 and a switching circuit 23 driven by the LED 22, the switching circuit 23 being connected in parallel between two terminals of the resistor $R_{GK}3$.

In Figs. 2, 3 and 4, the numeral 3 represents the resistor $R_{GK}$ formed as a P type impurity region, the numerals 5 and 15 represent N-type semiconductor substrates having a low impurity concentration, the numerals 7, 8 and 16 represent P type impurity regions, the numeral 14 represents an N+ type semiconductor substrate having a high impurity concentration, the numerals 9 and 17 represent N+ type impurity regions formed in the P type impurity regions 8 and 16 by doping N type impurities at a high concentration, the numerals 10 and 18 represent insulating layers, the numeral 11 represents an anode electrode of the PNPN device, the numeral 12 represents a P gate electrode of the PNPN device, the numeral 13 represents a cathode electrode of the PNPN device and the numeral 19 represents an emitter electrode of the PNPN device.

These electrodes 11, 12, 13 and 19 are made of aluminum or the like.

Every portion in the semiconductor substrate is interconnected with fine aluminum wires or the like.

The numeral 20 represents a PNPN device in which the resistor $R_{GK}$ is a diffusion type resistor, the device comprises a lateral type PN-P transistor having the P type impurity region 7, the N type semiconductor substrate 5 at a low impurity concentration and the P type impurity region 8, a vertical type N-PN+ transistor 2 having the N type semiconductor substrate 5 at a low impurity concentration, the P type impurity region 8 and the N type impurity region 9 and the diffusion resistor $R_{GK}3$.

The numeral 4 represents an NPN photo transistor, of which the collector saturation voltage $V_{CE(sat)}$ is suppressed below 0.6 volts and the voltage $V_{GK}$ between the gate and the cathode is designed to reveal less than 0.6 volts.

It has been well recognized that an epitaxial structure having a comb type emitter layer is employed to achieve the above results.

As shown in Fig. 2, the collector electrode of the photo transistor 4 which is drawn out of the N type semiconductor substrate 14 at a high impurity concentration is connected to the P gate electrode 12 with a wire and the emitter electrode 19 is connected to the cathode electrode 13 of the PNPN device.

The numeral 21 represents an LED which is used to make the PNP transistor 1 turn-on, whereas the numeral 22 represents an LED which is used to make the photo transistor 4 turn-on.

Now, the operation of the optically coupled semiconductor switch will be described hereinafter.

The turn-on operation is achieved by conducting the following steps.

Optical radiation achieved by driving the LED 21 causes the PNP transistor 1 to generates an optical current $I_{PNP}$ therein.

When the optical current $I_{PNP}$ flows through the diffusion resistor $R_{GK}3$, the voltage $V_{GK}$ between gate and the cathode reaches approximately 0.6 volts, whereby the multiplication ratio $\alpha_{NPN}$ increases and makes the device in a conductive state.

When the device turns into a conductive state, the self maintenance function keeps the device to be conductive even though the optical radiation from the LED 21 would be eliminated.

On the other hand, the turn-off operation is achieved by conducting the following steps.

Optical radiation from the LED 22 operates the photo transistor 4 and reduces the voltage $V_{GK}$ between the gate and the cathode to less than 0.6 volts

Then, the multiplication ratio $\alpha_{NPN}$ decreases effectively and the PNPN device will be turned-off.

Fig. 5 is a circuit diagram of the optically coupled semiconductor switch showing a second embodiment of the invention.

In this embodiment, the NPN photo transistor 4 in the switching circuit of the first embodiment is replaced by a PNP photo transistor 24.

The collector saturation voltage $V_{CE(sat)}$ of the PNP photo transistor 24 is required to remain less than 0.6 volts which is level enough to turn-off the photo PNPN switch.

Fig. 6 is a circuit diagram of the optically coupled semiconductor switch showing a third embodiment of the invention.

In this embodiment, there is provided a MOSFET 25, instead of the NPN photo transistor 4 in the aforementioned switching circuit, wherein the drain is connected to the P gate of the photo PNPN switch; the source is connected to the cathode of the photo PNPN switch and the insulating gate is connected to a plurality of diodes 26 connected each other in series which generates a control voltage in response to the optical radiation from the LED 22.

Furthermore, a driving method adapted to the optically coupled semiconductor switch according to the invention will be described.

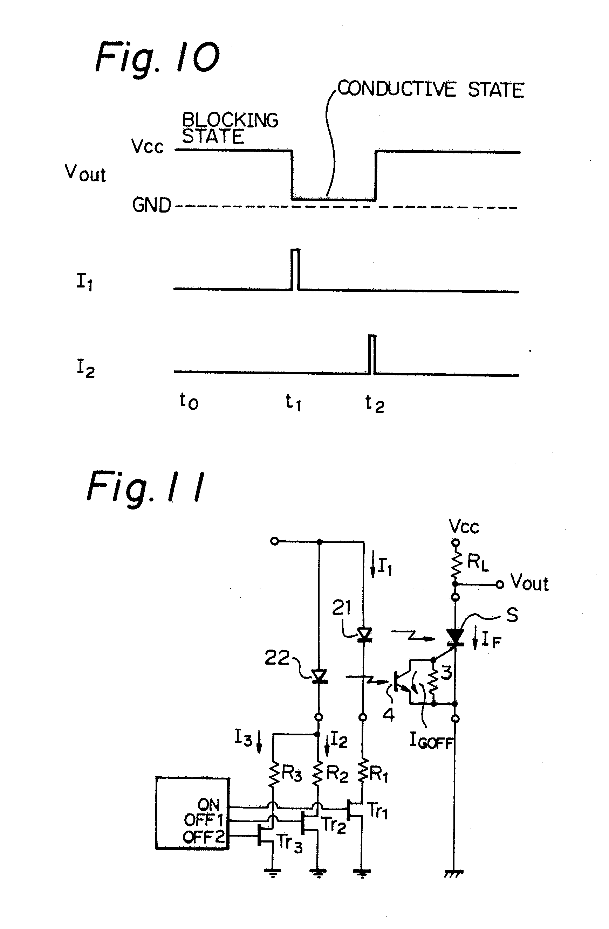

Generally, the switch shown in Fig. 9 can be driven by the pulses shown in Fig. 10. More detailed explanation will follow hereinafter.

The source voltage $V_{CC}$ is supplied to the thyristor S and the turn-off circuit through the load resistor $R_L$.

The LED 21 for driving and the resistor $R_1$ for restricting the current therethrough are connected in series and the current $I_1$, flows through the LED 21, whereas the LED 22 for driving and the resistor $R_2$ for restrict the current flow therethrough are connected in series and the current $I_2$ flows through the LED 22.

The optically coupled semiconductor switch mentioned above will turn-on from an off-state (from time to to time $t_1$) by driving the thyristor S at the time $t_1$ in a manner that a current pulse of a constant width is supplied to the LED 21.

The thyristor S is turned-off in accordance with the following steps.

Firstly, a current pulse of a constant width is supplied to the LED 22 at the time $t_2$.

Secondly, the NPN photo transistor 4 is activated by the optical radiation from the LED 22.

Then, the voltage $V_{GK}$ between the gate and the cathode is decreased to less than 0.6 volts to extremely decrease the effective multiplication ratio $\alpha_{NPN}$.

When the optically coupled semiconductor switch is driven in a manner set forth above, it may sometimes cause a so-called dV/dt erroneous operation because the voltage $V_{GK}$ reaches more than 0.6 volts when a transient current flows into the resistor $R_{GK}3$ due to a pulse voltage with sharp rising edge imposed between the anode and cathode of the PNPN device.

In this invention, the following driving method can be applied to decrease the dV/dt erroneous operation keeping low power consumption.

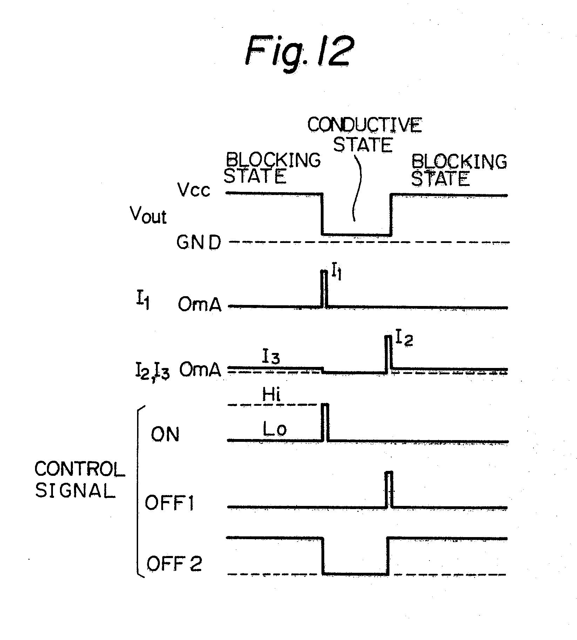

Fig. 11 is a driving circuit diagram adapted to an optically coupled semiconductor switch according to this invention and Fig. 12 is a wave form chart to explain an operation of the invention.

In Fig. 11, a load resistor $R_L$ isprovided in an output circuit; are resistors $R_1$ to $R_3$ control an current flowing through an LED provided in an input circuit; and switching transistors $T_{r1}$ to$T_{r3}$ control a driving system and is operated by a signal from a control portion 30.

In this embodiment shown in Fig. 12 in particular, the signal of OFF 2 is kept to be a high level in the blocking state and the current $I_3$ flows through the LED 22 with the transistor $T_{r3}$ being operated.

Then, the transistor 4 is turned-off by receiving the optical radiation from the LED 22. This driving method can be decrease the dV/dt erroneous operation.

Though a transient current is created in a PNPN device when a surge voltage with sharp rising edge is inputted into the PNPN device, the voltage $V_{GK}$ never exceeds 0.6 volts if the transistor 4 would be so operated as explained above, because the transient current is bypassed through the transistor 4.

Therefore, the erroneous operation will be extremely decreased. The current with which the LED 22 is driven is enough to be about 1 mA because the transient current is an order of approximately a few hundred μA in value at the most though it depends on the PNPN device.

In this embodiment, when a resistor $R_3$ of a few KΩ is relected, the current $I_3$ is set to be 1 mA in the blocking state.

When the blocking state should be turned on to achieve the conductive state, the current through the LED 22 must be 0 mA.

Accordingly, the ON signal of the control portion 30 must be set to a high level and both OFF 1 and OFF 2 signals to a low levels.

When the conductive state is turned off to achieve the blocking state, the current flowing through the resistor $R_{GK}3$ must be switched to flow through transistor 4.

The current $I_{GOFF}$ which must be flowed through the transistor 4 has the following relation set forth as equation (2) with the current $I_F$ which flows through the PNPN device.

$$I_F/I_{GOFF} = \alpha_{NPN}/(\alpha_{NPN} + \alpha_{PNP} - 1) \quad ... (2)$$

As $\alpha_{NPN}$ and $\alpha_{PNP}$ are usually set on the value of approximately 1 and 0.5, respectively, $I_{GOFF}$ $I_{F/2}$ can be achieved.

Accordingly, if $I_F$ equals to 100 mA, then $I_{GOFF}$ becomes 50 mA.

As described above, the turn-off operation can be accomplished when the LED is driven by a current $I_2$ larger than the current $I_3$, which is caused if the transistor $T_{r2}$ is so operated that current 50mA in value is provided to the transistor for turn-off.

Once the voltage $V_{GK}$ reaches a level of less than 0.6 volts by flowing the current through the transistor for turn-off, the aforementioned driving method under the blocking state can be applied later on.

## Claims

1. A PNPN semiconductor switch comprising:

(a) a resistor connected between a P gate and a cathode of the PNPN semiconductor switch;

(b) a first LED driving the switch;

(c) a second LED; and

(d) a switching circuit for withdrawing a voltage between the P gate and the cathode to a voltage level in which the PNPN switch can be turned-off when the PNPN switch is exposed to light radiation from the second LED.

2. The PNPN semiconductor switch according to claim 1 wherein the switching circuit comprises an NPN photo transistor having, a collector connected to the P gate and an emitter connected to the cathode.

3. The PNPN semiconductor switch according to claim 1 wherein the switching circuit a PNP photo transistor having, an emitter connected to the P gate and a collector connected to the cathode.

4. The PNPN semiconductor switch according to claim 1 wherein the switching circuit comprises a MOSFET having, a drain connected to the P gate, a source connected to the cathode and an insulating gate connected to a plurality of diodes serially connected each other for generating a control voltage when the switching sircuit is exposed to light radiation from the second LED.

5. A method for driving a PNPN semiconductor switch comprising steps of:

(a) driving the PNPN switch, a P gate and a cathode of the PNPN switch being connected through a resistor, by a first LED;

(b) turning-off the PNPN switch by closing the P gate and the cathode driven by a second LED;

(c) preserving the closing condition between the P gate and the cathode by providing the second LED with a small current when the PNPN switch remains an off state.

6. A PNPN semiconductor switch substantially as hereinbefore described with reference to the accompanying drawings.

7. A method for driving a PNPN semiconductor switch substantially as hereinbefore described with reference to the accompany

drawings.

0268430

Fig. 1

Fig. 2

Fig. 5

Fig. 6

0268430

*Fig. 3*

*Fig. 4*

0268430

Fig. 7

Fig. 8

Fig. 9

0268430

## Fig. 10

## Fig. 11

# Fig. 12